# EUROPEAN PATENT SPECIFICATION

(11) **EP 3 267 187 B1**
(45) Date of publication and mention of the grant of the patent: **15.04.2020**
(21) Application number: 16178557.1
(22) Date of filing: 08.07.2016
(51) Int. Cl.: G01N 27/414

(54) **SILICON CARBIDE BASED FIELD EFFECT GAS SENSOR FOR HIGH TEMPERATURE APPLICATIONS**
SILICIUMCARBIDBASIERTER FELDEFFEKTGASSENSOR FÜR HOCHTEMPERATURANWENDUNGEN
CAPTEUR DE GAZ À EFFET DE CHAMP À BASE DE CARBURE DE SILICIUM POUR APPLICATIONS À HAUTE TEMPÉRATURE

(43) Date of publication of application: 10.01.2018
(73) Proprietor: Volvo Car Corporation, 40 531 Göteborg (SE)
(72) Inventor: Andersson, Mike, 58734 Linköping (SE); Fashandi, Hossein, 58249 Linköping (SE)
(74) Representative: Kransell & Wennborg KB

(56) References cited:
- WO-A1-00/49660
- WO-A1-2010/115434
- US-A1- 2007 001 176

## Description

### Field of the Invention

The present invention relates to a silicon carbide (SiC) based field effect gas sensor and to a method of manufacturing such a gas sensor.

### Background of the Invention

Wide band gap semiconductor materials, such as silicon carbide (SiC), have recently attracted a lot of interest for the development of devices and electronics for high temperature and also high power applications. One example of current interest concerns the demands for power electronics to connect grid-level energy storage facilities to a power grid largely based on renewable, intermittent energy sources, such as wind and waves. The wide band gap (3.2 eV in the case of 4H-SiC, which is the most common polytype for device fabrication) permits operation at temperatures higher than that of Si based devices, the intrinsic carrier generation, in comparison to the doping related carrier concentration, and the pn-junction leakage being negligible even at temperatures exceeding 600 °C. In addition, SiC has 3 times the thermal conductivity of Si, facilitating easier transfer of any intrinsically generated heat and in conjunction with the higher permitted operation temperature relaxing demands on thermal management. A substantial reduction in size and weight of the passive/ active cooling for SiC as compared to Si based electronics devices/ systems is of particular interest for applications such as converters for Electric/ Hybrid Electric Vehicles (HEVs) or train engines, for which the ambient temperatures might be high and any added weight immediately results in "fuel penalty".

Its temperature related properties makes SiC interesting also in relation to devices for low-voltage high temperature applications such as ICs for oil, gas and geothermal well drilling telemetry, motor drive electronics, space exploration and, also due to the chemical inertness of the material, various physical and chemical sensors, such as pressure and gas sensors.

Combustion processes in e.g. internal combustion car engines, power plants, district heating plants, gas turbines, and domestic heating facilities generally lead to emissions of substances such as nitrogen oxides, hydrocarbons and carbon monoxide (CO), especially if the processes are neither optimized nor controlled. Deficiency or too much of excess air in the combustion processes lead to either incomplete combustion of the fuel or slow combustion kinetics, with the result that incompletely oxidized hydrocarbon species and CO are left in the exhaust or flue gases. Generally, combustion processes also lead to generation of nitrogen oxides and release of fuel-bound nitrogen and sulphur oxides, the emissions of which normally are reduced by post-combustion processes, e.g. catalytic conversion and wet scrubbing.

Optimizing and controlling a combustion process, as well as any post-combustion measures, in order to decrease the emissions requires monitoring and determination of certain gaseous substances, such as CO, NO, NO₂, in the exhaust or flue gases. The presently existing options regarding such monitoring and determination is however very limited due to the harsh conditions, e.g. high temperature, vibrations, and corrosive environments, encountered in the processes of interest. Most solid-state gas sensors are either not able to operate under harsh conditions or suffer long-term stability problems. As an example, in the special application of Exhaust Gas Recirculation (EGR), there is at present no existing satisfactory oxygen sensor for control of the exhaust recirculation (often referred to as an intake oxygen sensor). Due to the special conditions prevailing in the engine intake compartment, any kind of sensors being subjected to e.g. condensed water, soot, and oil residues, the Universal Exhaust Gas Oxygen (UEGO) sensor currently in use for exhaust or flue gas oxygen concentration assessment does not withstand the conditions encountered and is not able to fulfil the requirements on reliability set by the automotive industry. Resistive-type semiconducting metal oxide based sensors (commonly fabricated from materials like tin oxide - SnO₂) generally also suffer from long-term stability issues under conditions prevailing for this particular as well as other exhaust/ flue gas monitoring and combustion control applications, in addition to poor selectivity. Many other kinds of sensor technologies require the gas to be sampled, cooled and/or filtered before being subjected to the sensors, such as the sensor technology based on electrochemical cells. The various kinds of optical sensors that have been developed are quite expensive and suffer from undesired spatial fluctuations when directing the laser beam of the sensor to desired locations (also referred to as "beam wobble" or "pointing instability"), as well as long- term stability issues.

Gas sensors fabricated from SiC based field effect devices, utilizing the material properties referred to above, represent in this context a promising sensor technology for measuring important exhaust/flue gas constituents or other gas compositions from high temperature or harsh environment processes, e.g. the sensor device disclosed in US 7053425. The basic design of a field effect gas sensitive device is also given in e.g. Savage, S. M. et al. Mater. Sci. Forum, 353-356 (2001), pp. 747-752. Generally, the sensing mechanism in a field effect gas sensor based on a transistor is achieved as follows: A voltage is applied between the source and drain contacts and causes a current to flow through the channel region. A material capable of interacting with the substance or substances of interest in such a way that the electric field from the gate to the semiconductor is changed upon the interaction is used as the gate contact of the device, and is placed on top of the insulating layer over the channel region. The electric field from this gate contact to the semiconductor in turn modulates the current in the channel. As an example, if the field effect gas sensor is used for detecting H₂-gas, the gate contact is chosen to facilitate dissociative adsorption of the hydrogen molecule on its surface, producing hydrogen atoms that rapidly diffuse through the metal gate contact, adsorbing at the metal/insulator interface in the form of polarized hydroxyl (-OH) groups on the oxide surface. This polar layer at the interface changes the electric field from the contact and thus the current through the channel in such way that the change in current reflects the hydrogen coverage at the interface, which is directly related to the ambient hydrogen concentration. In varying the gate contact and insulator material(s) composition and structure as well as the device operating temperature and gate bias SiC based field effect sensors may also be tailored for the detection of different gaseous substances relevant to flue gas and exhaust monitoring.

The interest in such devices for this field of application has also increased mainly as a result of tightened emissions legislation for the automotive sector, specifically due to the resulting increased demands on accuracy in monitoring e.g. exhaust NOₓ, and Particulate Matter (PM) concentrations. In order to fulfil the requirements regarding NOₓ emissions, closed-loop control of the post-combustion after-treatment measure referred to as Selective Catalytic Reduction (SCR) of nitrogen oxides by ammonia (involving the release of water-dissolved urea into the hot exhaust stream, where it forms ammonia which reacts with NOₓ to produce harmless nitrogen, N2, and water, H₂O) is desired. For the realization of such closed-loop control of urea dosing, in order to achieve very high level of NOₓ reduction without the generation of substantial NH₃ emissions (the release of which will contribute to the formation of NOₓ in the atmosphere), it is necessary to accurately monitor the downstream exhaust concentrations of either NOₓ or NH₃ (or preferably both). Of the presently commercially available options only one kind of sensor, based on the same kind of basic sensor technology as the above mentioned UEGO sensor, the amperometric YSZ (Yttria Stabilized Zirconia) solid electrolyte sensor technology, is able to reliably detect and monitor exhaust NOₓ concentrations downstream of the SCR system. This sensor technology, however, suffers from substantial cross-sensitivity to ammonia, making direct, accurate measurements of downstream NOₓ concentrations challenging.

As of yet the only really promising sensor technology for the monitoring of exhaust ammonia concentration is based on the SiC field effect sensor platform, which also benefits from the extremely low cross-sensitivity to NOₓ, thereby making possible the realization of accurate determination of both NOₓ and NH₃ concentrations when combined with the YSZ solid electrolyte based sensor technology. In addition to NH3 monitoring, the SiC based field effect sensor platform is also of interest for the development of both NOₓ and PM as well as O₂ sensor elements, not the least in relation to the EGR control application referred to above. With its good resistance to thermal shock, which may result from the impingement of water droplets on its surface, and soot deposition, the SiC based field effect sensor platform is a promising candidate for the realization of such intake oxygen sensors. In these as well as the NH₃ monitoring application the sensor elements have to withstand being subjected to or operated at temperatures of, and for very short moments in excess of, 600 °C, during e.g. the regeneration of particle filters.

Also other fields of application are of interest in relation to high temperature operated gas sensors based on SiC field effect devices, e.g. monitoring of flue gas concentrations of different substances such as CO,O₂ and SOₓ to control the combustion process and flue gas after-treatment systems as well as various other processes, examples including (but not limited to) processing of chemicals, oil refining, biofuel production, CO₂ sequestration and storage processes, fuel reformer and fuel cell monitoring and control etc. Furthermore, intermittent operation of high temperature gas sensors based on SiC field effect devices might also prove interesting for the fields of environmental monitoring and medical diagnostics.

However, neither field effect gas sensors nor other kinds of discrete semiconductor devices or ICs based on SiC have yet found any commercial success for the really high temperature applications (> 450°C), mainly due to reliability issues. In view of long-term reliable high temperature device operation, including sensors, general critical issues are e.g. matching of the temperature expansion and heat conductivity of the materials combined in the device as well as the high temperature (and especially temperature cycling) endurance of electrical leads, contacts, and protective passivation/ encapsulation materials. For low voltage high temperature devices the most prominent reasons behind long-term degradation result from die attachment and contact failure, the latter due to the degradation of metallizations for protective capping and/ or passivation layers of electrical ohmic contacts as well as electrical leads/ bond pad stacks and the subsequent restructuring/ oxidation of the ohmic contacts when oxygen diffuses through the metal capping layers. Although measures have been taken to improve the reliability of SiC-based field effect gas sensors and other devices for high temperature applications, problems with the structural integrity and/or oxidation of conductive (ohmic) contact and protective/ passivation layers remain for operation temperatures of about 500°C and above, so far preventing their use in a number of the above mentioned applications.

WO2010/115434 discloses a field effect gas sensor including a SiC semiconductor structure and WO00/49660 discloses a diffusion barrier layer inside an integrated circuit.

### Summary

In view of above-mentioned and other drawbacks of the prior art, it is an object of the present invention to provide an improved SiC-based field effect gas sensor, in particular a SiC-based field effect gas sensor capable of long-term reliable operation in high temperature and harsh environment applications.

According to a first aspect of the present invention, it is therefore provided a field effect gas sensor as defined by claim 1.

A field effect gas sensor refers to any type of field effect electronic device in which an electric field changes as a response to one or several specific molecules in the ambient environment.

The SiC (silicon carbide) semiconductor structure may be doped, and the doping may be different in different parts of the SiC semiconductor structure. Further, the SiC semiconductor structure may include one or more epitaxial layers, i.e. layers deposited/grown on top of or on the surface of a SiC semiconductor substrate. The epitaxial layer(s) may also be doped, and the doping may be different in different parts of the epitaxial layer(s).

By "ohmic contact layer" should, in the context of the present application, be understood a layer of material capable of forming an "ohmic contact" with the SiC semiconductor structure. The term "ohmic contact" refers to a metallic-semiconductor contact with very low resistance independent of applied voltage, i.e. a contact having no or a very small potential barrier at the metallic material-semiconductor interface.

By "electron insulating layer" should, in the context of the present application, be understood a layer of a material that does not conduct an electrical current, i.e. an insulator. Such insulating layers are known to a person skilled in the art of semiconductor technology.

According to various embodiments of the invention, the field effect gas sensor may be realized as a MIS/MOS (Metal Insulator Semiconductor/ Metal Oxide Semiconductor) capacitor, a Schottky diode or a field effect transistor.
transition-metal oxide covering the ohmic contact layer. In these embodiments, the fourth portion of the SiC semiconductor structure is
The above-mentioned field effect transistor may be a Metal Oxide Semiconductor Field Effect Transistor (MOSFET), a Metal Insulator Semiconductor Field Effect Transistor (MISFET), a Metal Semiconductor Field Effect Transistor (MESFET), a Heterostructure Field Effect Transistor (HFET), or a Metal Insulator Semiconductor Heterostructure Field Effect Transistor (MISHFET).

Some of the above-mentioned field effect gas sensor configurations, as well as different layers configured to interact with different gaseous substances in a gas mixture are described in Linköping Studies in Science and Technology, Dissertation No: 931, "Studies of MISiC-FET sensors for car exhaust gas monitoring" by Helena Wingbrant, which is hereby incorporated by reference in its entirety.

The present invention is based upon the finding that conventional metal barrier layers that are capable of protecting the ohmic layer(s) of contact structure(s) in a SiC-based field effect gas sensor in temperatures of up to, say, 450°C cannot prevent oxidation of the ohmic layer(s) at higher temperatures, such as 600°C or higher.

The present inventors have now found that a layer of an electrically conducting metal oxide belonging to the group of mid-transition-metal-oxides, including (but not limited to) e.g. iridium oxide (IrO₂) and rhodium oxide (RhO₂) can protect the underlying ohmic layer(s) from oxidation for a long period of time at significantly higher temperatures.

Barrier layers formed by mid-transition-metal oxides exhibit low resistivity and almost metallic behavior regarding electrical conductance.

Among the mid-transition-metal oxides, iridium oxide and rhodium oxide exhibit particularly advantageous properties, including structural integrity and resistance to oxygen in-diffusion at temperatures up to about 750°C.

Furthermore, for both IrO₂ and RhO₂ the reconstructed oxide surfaces exhibit excellent stability and do not react with known ohmic layers, such as NiSiₓ, Ti₃SiC₂, TiₓAl_{y}C etc., leaving the ohmic layer intact and with retained ohmic properties.

Another general advantage of these barrier layer materials (mid-transition-metal oxides) is in their much smaller thermal expansion mismatch with the other passivation materials (e.g. SiO₂ and Si₃N₄) as compared to previously used barrier layers made of certain pure metals (Pt, Au, Al,...). The CTEs (Coefficient of thermal expansion) of silicon nitride and oxide are in the range 3-4 ppm/K and the one for IrO₂ approximately 5-6 ppm/K, whereas the CTE of the above-listed metals range from 10 to 22 ppm/K. Using e.g. IrO₂ as the second layer, the third and fourth, and so forth, passivation layers have been shown to be structurally unaffected by temperature cycling up to 750 °C, which is advantageous since these passivation layers are normally needed in order to protect the device surface on other parts of the chip.

By the application of one (or more) of the above listed conducting metal oxides as protective layer on top of, and completely covering the ohmic contact layer, the temperature range over which the SiC based field effect gas sensor according to embodiments of the present invention can be reliably used with good long-term stability can be extended to also covering temperatures well above 600°C without any degradation (oxidation, restructuring, delamination, etc.) of neither the ohmic contact layer, nor the oxide/ nitride passivation layers.

Being able to extend the range of operation temperatures over which the field effect gas sensor can be reliably operated to also encompass 600 °C opens up the possibility to address applications such as on-line monitoring, diagnostics and control of exhaust emissions after-treatment systems. As previously discussed, for a number of the parameters desired to monitor, one example being ammonia concentration downstream of the SCR catalyst, there are no viable commercially available sensor options existing at the moment. There are also doubts whether the sensor technology which exist today to monitor some of the other parameters, such as tailpipe-out concentration of nitrogen oxides, will be able to fulfil the accuracy requirements when emissions legislation in the near future will be made even tighter. Since SiC based field effect gas sensors are able to dynamically monitor really small concentrations of ammonia with negligible interference from other gaseous substances and generally exhibit much better accuracy and signal-to-noise ratio the SiC FE based sensor technology could very well offer the solution to both of the discussed issues, given the improvement in high temperature durability/ reliability enabled through embodiments of the present invention.

According to various embodiments of the field effect gas sensor of the present invention, the field effect gas sensor may be provided in the form of a field effect transistor. In these embodiments, the second portion of the SiC semiconductor structure may be (n+ or p+) doped, and the field effect gas sensor may further comprise a third contact structure conductively connected to a third (n+ or p+) doped portion of the SiC semiconductor structure, different from the first portion and the second portion. Like the second contact structure, the third contact structure may comprise an ohmic contact layer in direct contact with the third portion of the SiC semiconductor structure; and a barrier layer formed by an electrically conducting mid-transition-metal oxide covering the ohmic contact layer. In these embodiments, the first portion of the SiC semiconductor structure is arranged between the second portion and the third portion, so that the first contact structure forms the gate, and the second and third contact structures form the source and the drain, respectively of the field effect transistor. In these embodiments, the field effect gas sensor may further comprise a fourth contact structure conductively connected to a fourth (n+ or p+) doped portion of the SiC semiconductor structure, different from the first to third portions. Like the second and third contact structures, the fourth contact structure may comprise an ohmic contact layer in direct contact with the fourth portion of the SiC semiconductor structure; and a barrier layer formed by an electrically conducting mid-transition-metal oxide covering the ohmic contact layer. In these embodiments, the fourth portion of the SiC semiconductor structure is arranged so that the fourth contact structure forms the substrate (body) terminal of the field effect transistor.

As was mentioned further above, at least one of the electron insulating layer and the first contact structure is exposed to the gas mixture, and is configured to interact with the gaseous substance to be detected, such that the gate to semiconductor electric field will depend on the presence of the gaseous substance in the gas mixture. The gas-induced modulation of the electric field will affect the I-V characteristics of the field effect transistor, allowing (at least) the presence of the gaseous substance in the gas mixture to be monitored by monitoring an electrical property, e.g. voltage or current, of the field effect transistor. For instance, the drain-source voltage may be kept constant and the drain-source current monitored.

According to a second aspect of the present invention, there is provided a method as defined by claim 9.

Further embodiments of, and effects obtained through this second aspect of the present invention are largely analogous to those described above for the first aspect of the invention.

In summary, the present invention relates to a field effect gas sensor, for detecting the presence of at least one gaseous substance in a gas mixture, the field effect gas sensor comprising: a SiC semiconductor structure; an electron insulating layer covering a first portion of the SiC semiconductor structure; a first contact structure at least partly separated from the SiC semiconductor structure by the electron insulating layer; and at least one second contact structure conductively connected to at least one second portion of the SiC semiconductor structure, wherein at least one of the electron insulating layer and the first contact structure is configured to interact with the gaseous substance to change an electrical property of the SiC semiconductor structure; and wherein the at least one second contact structure comprises: an ohmic contact layer in direct contact with the at least one second portion of the SiC semiconductor structure; and at least one barrier layer formed by an electrically conducting mid-transition-metal oxide covering the ohmic contact layer.

### Brief Description of the Drawings

These and other aspects of the present invention will now be described in more detail, with reference to the appended drawings showing an example embodiment of the invention, wherein:
Fig. 1 illustrates a field effect gas sensor of the MOSFET/MISFET type according to an embodiment of the present invention;
Fig. 2 illustrates a field effect gas sensor of the MOS capacitor type according to an embodiment of the present invention;
Fig. 3 illustrates a field effect gas sensor of the Schottky diode type according to an embodiment of the present invention;
Fig. 4 illustrates an example of a suitable means for electrically connecting and heating the field effect gas sensor according to an embodiment of the present invention; Fig. 4A shows a front view, Fig. 4B shows a backside view and Fig. 4C shows a side view, in which a field effect gas sensor of the present invention is mounted to the suitable means for electrically connecting and heating;
Fig. 5 illustrates an example of an encapsulated field effect gas sensor according to an embodiment of the present invention;
Fig. 6 illustrates an example of a configuration for detection of a gaseous substance in a gas flow using the field effect gas sensor according to an embodiment of the present invention;
Figs 7a-b illustrate the temperature stability of exemplary SiC-based field effect transistor gas sensors with conventional barrier layers on the ohmic contact layers; and
Fig 8 illustrates the temperature stability of a SiC-based field effect transistor gas sensors according to an example embodiment of the present invention with barrier layers made of IrO₂.

### Detailed Description of Example Embodiments

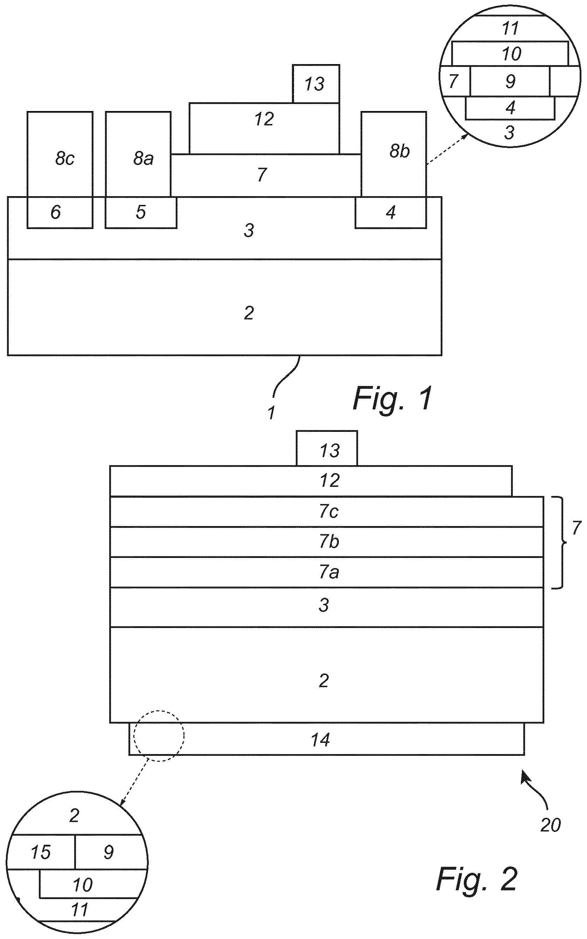

Fig. 1 displays an example of a field effect gas sensor of the MOSFET/ MISFET type 1 according to an embodiment of the present disclosure. The field effect gas sensor of the MOSFET/ MISFET type 1 comprises a semiconductor layer 2 of e.g. n-type doped SiC. On the semiconductor layer 2, an epilayer 3 (also of SiC), of p-type (doping concentration 5-10¹⁵/cm³) is grown to a thickness of approximately 10 µm. In the epilayer, 3 doped regions are created e.g. by ion implantation to form a drain region 4 of n-type, a source region 5 of n-type and a substrate region 6 of p-type (doping concentration approximately -10²⁰/cm³). On top of the epilayer 3 an electron insulating layer 7 is grown, consisting of e.g. a thermally grown SiO₂ layer to an approximate thickness of 500 Å, and an LPCVD deposited layer of silicon nitride (Si₃N₄) of approximate thickness 250 Å, which is densified to create a thin layer of silicon dioxide on top of the nitride, typically 50 Å.

Three contact structures 8a-c to the source 5, drain 4 and substrate regions 6 of the epilayer 3, respectively, are then created. The contact structures 8a-c may be processed by first etching the electron insulating layer 7 (e.g. using standard photo-lithographic patterning and wet etching techniques or dry etching techniques such as reactive ion etching) over the drain region 4 of n-type, the source region 5 of n-type and over the substrate region 6. Onto the implanted areas where the electron insulating layer has been removed the contact structures 8a-c may then be created by the following process:
First, the ohmic contact layer 9 is formed by, for example, deposition of Nickel (Ni) to an approximate thickness of 500 Å followed by rapid thermal annealing in argon at 950°C and then deposition of approximately 50 Å titanium (Ti).

Thereafter, a barrier layer 10 is deposited to completely cover the ohmic contact layer 9, to protect the ohmic contact layer 9 from oxidation at high operating temperatures (such as above 500 °C). This barrier layer 10 may be configured so as to also cover part of the electron insulating layer 7. The protective oxygen diffusion barrier materials that may be used for the barrier layer 10 is selected from the group of metal oxides consisting of IrO₂, RuO₂, RhO₂, and ReO₃, preferably from one of IrO₂ and RhO₂, and may also be arranged as a layered combination, as a composite or any other kind of mixture of said materials. At least part of the oxygen diffusion barrier layer may also include a layer composed of a metal such as Pt or Au. The oxygen diffusion barrier materials can be processed/fabricated in the preferred thin-film layout and structure by a number of different methods, including both CVD (Chemical Vapor Deposition) based methods, such as ordinary CVD, MBE (Molecular Beam Epitaxy) and ALD (Atomic Layer Deposition), and PVD (Physical Vapor Deposition) based methods, such as thermal/ e-beam evaporation, RF/DC magnetron sputtering, and Pulsed Laser Deposition (PLD). The currently preferred methods are RF/DC magnetron sputtering and Pulsed Laser Deposition, in both cases by using a metal or metal oxide target and running the process in presence of a certain partial pressure of oxygen added to the vacuum deposition chamber.

On top of the barrier layer 10, except where it is intended to electrically contact the contact structures 8a-c through various bonding techniques, a conventional passivation layer 11 may be applied using methods known to one of ordinary skill in the art.

Onto at least a part of the electron insulating layer 7, an electrical contact 12, which may be a gate contact when the field effect gas sensor is of MOSFET/ MISFET type, is created, comprising a thin film of at least one material including (but not limited to) metals such as Au, Pt, Ir, and Rh, binary metal oxides, such as FeOₓ, IrOₓ and RuOₓ, binary sulfides and selenides such as MoS₂, MoSe₂, and WS₂, ternary compounds such as SrTiO₃, BaCoO₃, and LaMnO₃, and any material with the general formula ABO₃, specifically of the perovskite type, as well as any combinations or mixtures of these materials, where at least one of the materials is electrically conductive. At least a part of the electrical contact 12 may be deposited by sputtering, in the case of oxide materials in an oxygen ambient, or evaporation to a thickness of up to 500 Å. On top of the electrical gate contact 12 a thin, discontinuous layer of a catalytic or otherwise promoter material, e.g. 25Å Pt, may be deposited. Part of the electrical gate contact 12 may be in contact with a contact layer 13 comprising a double layer of Ti/Pt films of a thickness of approximately 25 and 200 Å, respectively. Adsorption of the one or more gaseous substance(s) of interest on the electrical gate contact 12 induces, either directly or through reactions with adsorbed oxygen anions, a change in the gate to semiconductor electric field and thus a change in conductance in the channel between the source 5 and drain 4 regions. The voltage over the field effect gas sensor of the MOSFET/ MISFET type when keeping a constant current through the gas sensor thus reflects the presence and/or ambient concentration of the gaseous substance to be detected.

Fig. 2 displays an example of a field effect gas sensor of MOS capacitor type 20 according to an embodiment of the present disclosure. The field effect gas sensor of MOS capacitor type 20 has a semiconductor layer 2 of SiC, being of n-type semi-insulating material, onto which an epilayer 3 of n-type and of approximately 5 µm thickness, is grown. On top of the epilayer 3 an electron insulating layer 7 is created. The electron insulating layer 7 comprises a stack of three insulators 7a, 7b and 7c consisting of a thermally grown oxide (SiO₂) 7a and an LPCVD deposited and densified silicon nitride (Si₃N₄) 7b, the latter also resulting in a thin silicon dioxide film 7c on top of the nitride, to an approximate total thickness of the electron insulating layer 7 of 800 Å.

Further, a backside contact structure 14, is created on the semiconductor layer through the following process:
First, the ohmic contact layer 9 is formed by, for example, deposition of Nickel (Ni) to an approximate thickness of 500 Å followed by rapid thermal annealing in argon at 950°C and then deposition of, approximately 500 Å tantalum silicide (TaSi₂) and 4000 Å platinum (Pt) or optionally 50 Å titanium (Ti) and 4000 Å platinum (Pt)

Thereafter, a barrier layer 10 is deposited to completely cover the ohmic contact layer 9, as well as a part of a first passivation layer 15, to protect the ohmic contact layer 9 from oxidation at high operating temperatures (such as above 500 °C). The barrier layer 10 may be configured so as to also cover part of the electron insulating layer 7. The protective oxygen diffusion barrier materials that may be used for the barrier layer 10 is selected from the group of metal oxides consisting of IrO₂, RuO₂, RhO₂, and ReO₃, preferably from one of IrO₂ and RhO₂, and may also be arranged as a layered combination, as a composite or any other kind of mixture of said materials. At least part of the oxygen diffusion barrier layer may also include a layer composed of a metal such as Pt or Au. The oxygen diffusion barrier materials can be processed/fabricated in the preferred thin-film layout and structure by a number of different methods, including both CVD (Chemical Vapor Deposition) based methods, such as ordinary CVD, MBE (Molecular Beam Epitaxy) and ALD (Atomic Layer Deposition), and PVD (Physical Vapor Deposition) based methods, such as thermal/ e-beam evaporation, RF/DC magnetron sputtering, and Pulsed Laser Deposition (PLD). The currently preferred methods are RF/DC magnetron sputtering and Pulsed Laser Deposition, in both cases by using a metal or metal oxide target and run the process in presence of a certain partial pressure of oxygen added to the vacuum deposition chamber.

On top of the barrier layer 10, except where it is intended to electrically contact the backside contact structure 14 through various bonding techniques, a conventional second passivation structure 11, comprising of one or more materials/ layers may be applied using methods known to one of ordinary skill in the art.

Onto at least a part of the electron insulating layer 7, an electrical contact 12, which may be a gate contact when the field effect gas sensor is of MOSFET/ MISFET type, is created, comprising a thin film of at least one material including (but not limited to) metals such as Au, Pt, Ir, and Rh, binary metal oxides, such as FeOₓ, IrOₓ and RuOₓ, binary sulfides and selenides such as MoS₂, MoSe₂, and WS₂, ternary compounds such as SrTiO₃, BaCoO₃, and LaMnO₃, and any material with the general formula ABO₃, specifically of the perovskite type, as well as any combinations or mixtures of these materials, where at least one of the materials is electrically conductive. At least a part of the electrical contact 12 may be deposited by sputtering, in the case of oxide materials in an oxygen ambient, or evaporation to a thickness of up to 500 Å. On top of the electrical gate contact 12 a thin, discontinuous layer of a catalytic or otherwise promoter material, e.g. 25Å Pt, may be deposited. Part of the electrical gate contact 12 may be in contact with a contact layer 13 comprising a double layer of Ti/Pt films of a thickness of approximately 25 and 200 Å, respectively.. Adsorption of the one or more gaseous substance(s) of interest on the electrical contact 12 induces, either directly or through chemical reactions e.g. with adsorbed oxygen anions, a change in material properties and/ or a change in the gate to semiconductor electric field, thus changing the capacitance-voltage characteristics of the field effect gas sensor of MOS capacitor type. The bias voltage over the field effect gas sensor when keeping a constant capacitance over the sensor thus reflects the presence and/ or ambient concentration of the one or more gaseous substance(s) of interest.

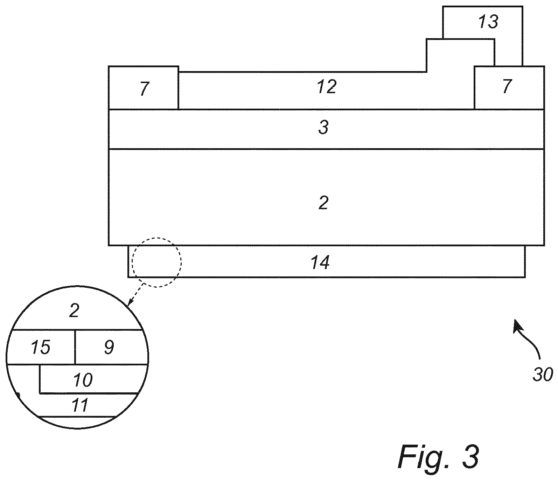

Fig. 3 displays an example of a field effect gas sensor of Schottky diode type 30 according to an embodiment of the present disclosure. The field effect gas sensor of Schottky diode type 30 has a semiconductor layer 2 of e.g. n-doped SiC. Onto the semiconductor layer 2, an epilayer 3 of n-type (e.g. doping concentration 3×10¹⁶/cm³) is grown to a thickness of approximately 10 µm. On top of the epilayer 3 an electron insulating layer 7 is created, consisting of a thermally grown oxide (SiO₂) layer to an approximate total thickness of approximately 800 Å.

Further, a backside contact structure 14, is created on the semiconductor layer through the following process:
First, the ohmic contact layer 9 is formed by, for example, deposition of Nickel (Ni) to an approximate thickness of 500 Å followed by rapid thermal annealing in argon at 950°C and then deposition of, approximately 500 Å tantalum silicide (TaSi₂) and 4000 Å platinum (Pt) or optionally 50 Å titanium (Ti) and 4000 Å platinum (Pt).

Thereafter, a barrier layer 10 is deposited to completely cover the ohmic contact layer 9, as well as a part of a first passivation layer 15, to protect the ohmic contact layer 9 from oxidation at high operating temperatures (such as above 500 °C). The barrier layer 10 may be configured so as to also cover part of the electron insulating layer 7. The protective oxygen diffusion barrier materials that may be used for the barrier layer 10 is selected from the group of metal oxides consisting of IrO₂, RuO₂, RhO₂, and ReO₃, preferably from one of IrO₂ and RhO₂, and may also be arranged as a layered combination, as a composite or any other kind of mixture of said materials. At least part of the oxygen diffusion barrier layer may also include a layer composed of a metal such as Pt or Au. The oxygen diffusion barrier materials can be processed/fabricated in the preferred thin-film layout and structure by a number of different methods, including both CVD (Chemical Vapor Deposition) based methods, such as ordinary CVD, MBE (Molecular Beam Epitaxy) and ALD (Atomic Layer Deposition), and PVD (Physical Vapor Deposition) based methods, such as thermal/ e-beam evaporation, RF/DC magnetron sputtering, and Pulsed Laser Deposition (PLD). The currently preferred methods are RF/DC magnetron sputtering and Pulsed Laser Deposition, in both cases by using a metal or metal oxide target and run the process in presence of a certain partial pressure of oxygen added to the vacuum deposition chamber.

On top of the barrier layer 10, except where it is intended to electrically contact the backside contact structure 14 through various bonding techniques, a conventional second passivation layer 11 may be applied using methods known to one of ordinary skill in the art.

The electron insulating layer 7 may be patterned by conventional photolithographic methods and wet etched in 50 percent HF.

Onto at least a part of the electron insulating layer 7, an electrical contact 12, which may be a gate contact when the field effect gas sensor is of MOSFET/ MISFET type, is created, comprising a thin film of at least one material including (but not limited to) metals such as Au, Pt, Ir, and Rh, binary metal oxides, such as FeOₓ, IrOₓ and RuOₓ, binary sulfides and selenides such as MoS₂, MoSe₂, and WS₂, ternary compounds such as SrTiO₃, BaCoO₃, and LaMnO₃, and any material with the general formula ABO₃, specifically of the perovskite type, as well as any combinations or mixtures of these materials, where at least one of the materials is electrically conductive. At least a part of the electrical contact 12 may be deposited by sputtering, in the case of oxide materials in an oxygen ambient, or evaporation to a thickness of up to 500 Å. On top of the electrical gate contact 12 a thin, discontinuous layer of a catalytic or otherwise promoter material, e.g. 25Å Pt, may be deposited. Part of the electrical gate contact 12 may be in contact with a contact layer 13 comprising a double layer of Ti/Pt films of a thickness of approximately 25 and 200 Å, respectively. The contact layer 13 may also cover a part of the electron insulating layer 7. Adsorption of the gaseous substance of interest on the electrical contact 12 induces, either directly or through reactions with adsorbed oxygen anions, a change in the Schottky barrier, thus changing the current of the field effect gas sensor of Schottky diode type. The bias voltage over the field effect gas sensor when keeping a constant current over the sensor thus reflects the presence and/ or ambient concentration of the gaseous substance of interest.

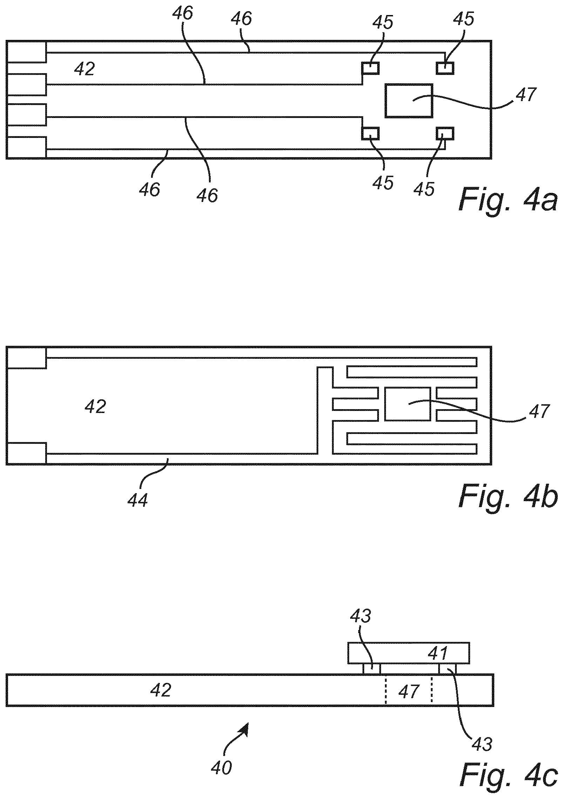

Fig. 4 displays an example of a suitable means 40 for electrically connecting and heating the field effect gas sensor of the present disclosure. An alumina substrate 42 (or a substrate of some other suitable material) has connector lines 46 and contact pads 45 printed on the front side and a resistive-type heater line 44 on the backside. The field effect gas sensor 41 is flipped upside-down and bumps 43 of e.g. gold or platinum connect the field effect gas sensor 41 to the contact pads 45 and connector lines 46 printed on the alumina substrate. An opening 47 is created in the alumina substrate just above the electrical contact (the gate contact in transistor devices) of the field effect gas sensor 41 to allow the ambient gas mixture to reach the electrical contact of the field effect gas sensor 41. The resistor structure 44 is printed on the backside of the alumina substrate 42 to facilitate heating of the sensor device. All connector lines 46 are printed in such a way that they can be easily contacted at the end of the alumina substrate by e.g. a clamp contact.

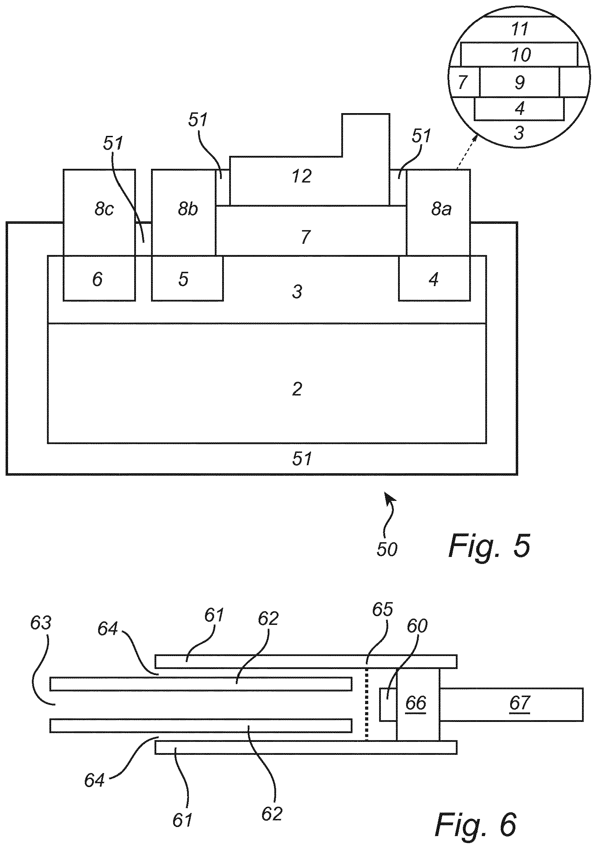

Fig. 5 displays an example of a field effect gas sensor of the present disclosure comprising means for encapsulation 50. The semiconductor layer 2, the epilayer 3, and the electron insulating layer 7are covered with an encapsulation layer 51 of a suitable material, e.g. Si₃N₄ or SiO₂. The electrical contact 12 is however in contact with the ambient to facilitate detection of at least one substance of interest in a gas mixture.

Fig. 6 displays an example of a configuration for detection of a gaseous substance in a gas mixture flow using a field effect gas sensor 60 according to an embodiment of the present invention. The configuration comprising the field effect gas sensor 60 is mounted in the gas flow of interest, e.g. in a tail pipe, a flue gas channel, a chimney etc. The field effect gas sensor 60 is placed inside an outer tube 61 a short distance from the end of an inner tube 62. The inner tube 62 is of smaller diameter than the outer tube 61 and disposed within the outer tube 61 such that there is a gap between the inner 62 and the outer 61 tube. Furthermore, the inner tube 62 extends outside the outer tube 61 at the end opposite to the location of the field effect gas sensor 60. In between the end of the inner tube 62 and the field effect gas sensor 60 a coarse filter 65 is applied such that it spans the cross section of the outer tube 61. The outer 61 and inner 62 tubes are assembled such that the gas mixture of interest can pass in through the outer tube opening 64, come into contact with the field effect gas sensor 60 and exit through the opening of the inner tube 63. The outer tube 61 is also supplied with a gas-tight thermal barrier 66 and means for electrically connecting the sensor device 67 as well as a thread for screwing it into place.

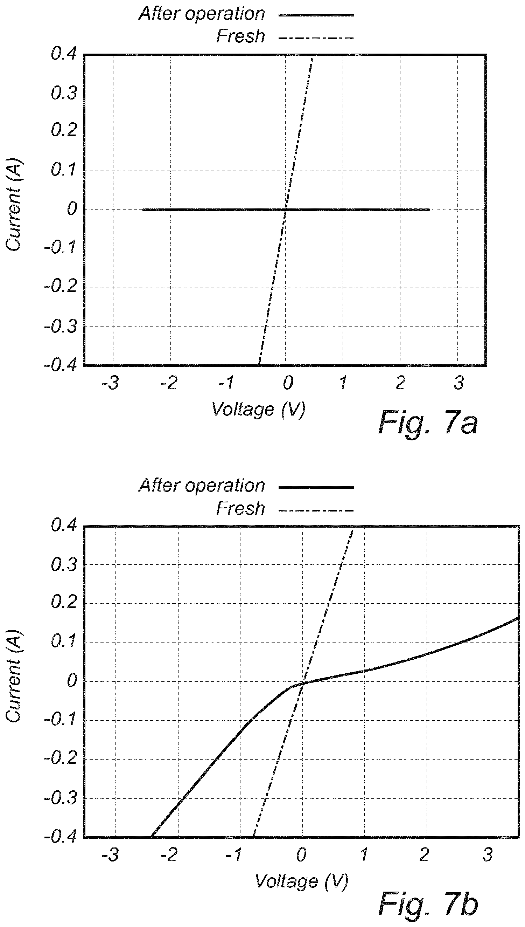

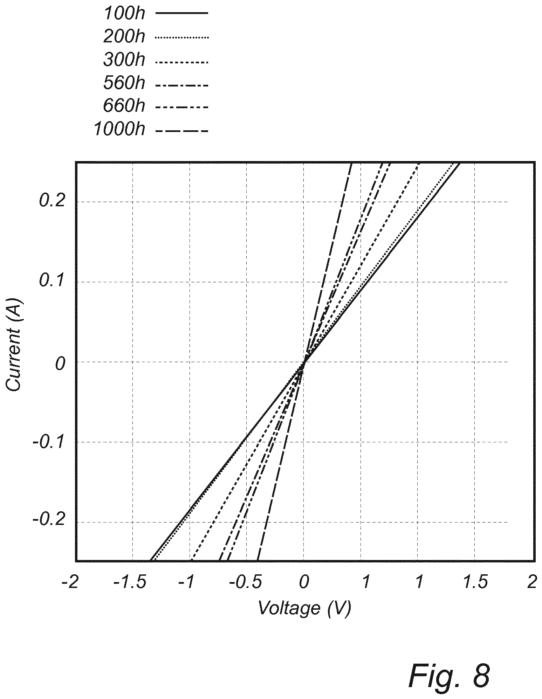

In the following, the improvement in temperature stability of SiC-based field effect sensors according to embodiments of the present invention will be illustrated with reference to figs 7a-b and fig 8.

Figs 7a-b show the current-voltage-characteristics (I/V-characteristics) of the same kind of ohmic contact - Ti₃SiC₂ - before and after 100 hours of operation at 600°C when applying platinum (fig 7a) and iridium (fig 7b) as the respective conductive ohmic contact protective (capping) layer. As can be seen, the Pt protective layer (which otherwise has been quite commonly used as an oxygen diffusion barrier in devices for operation up to approximately 450°C) does not prevent the fairly rapid in-diffusion of oxygen and subsequent oxidation of the ohmic contact layer, turning the contact into an insulating oxide (preventing any current to pass for at least low voltages). Also Ir-capped ohmic contacts degrade over time as can be seen from the no longer linear I/V-characteristics after 100 hours of operation at 600°C.

Fig 8 shows the I/V-characteristics of the same kind of Ti₃SiC₂ ohmic contact as in figs 7a-b, but when an IrO₂ layer is used as barrier layer for 600°C operation. As can be seen in fig 8, the performance was actually improved over the course of the experiment; the contact resistance decreased (the slope of the linear I/V-characteristics increasing) with time, at least for the 1000 hours recorded here.

The person skilled in the art realizes that the present invention by no means is limited to the preferred embodiments described above. On the contrary, many modifications and variations are possible within the scope of the appended claims.

In the claims, the word "comprising" does not exclude other elements or steps, and the indefinite article "a" or "an" does not exclude a plurality. A single processor or other unit may fulfill the functions of several items recited in the claims. The mere fact that certain measures are recited in mutually different dependent claims does not indicate that a combination of these measured cannot be used to advantage. Any reference signs in the claims should not be construed as limiting the scope.

## Claims

1. A field effect gas sensor (1; 20; 30), for detecting a presence of a gaseous substance in a gas mixture, said field effect gas sensor comprising:
a SiC semiconductor structure (2; 3; 4; 5; 6);
an electron insulating layer (7) covering a first portion of said SiC semiconductor structure;
a first contact structure (12) at least partly separated from said SiC semiconductor structure by said electron insulating layer (7); and
a second contact structure (8b; 14) conductively connected to a second portion (4) of said SiC semiconductor structure, different from said first portion,
wherein at least one of said electron insulating layer (7) and said first contact structure (12) is configured to interact with said gaseous substance to change an electrical property of said SiC semiconductor structure; and
wherein said second contact structure (8b; 14) comprises:
an ohmic contact layer (9) in direct contact with the second portion (4) of said SiC semiconductor structure; and
a barrier layer (10) covering said ohmic contact layer,
said barrier layer being formed by an electrically conducting metal oxide selected from the group of metal oxides consisting of IrO₂, RuO₂, RhO₂, and ReO₃.

2. The field effect gas sensor (1; 20; 30) according to claim 1, wherein said electrically conducting mid-transition-metal oxide is selected from the group consisting of iridium oxide and rhodium oxide.

3. The field effect gas sensor (1; 20; 30) according to claim 1 or 2, wherein said second portion of the SiC semiconductor structure is doped.

4. The field effect gas sensor (1) according to claim 3, further comprising a third contact structure (8a) conductively connected to a third portion (5) of said SiC semiconductor structure, different from said first portion and said second portion (4),
wherein:
said third contact structure (8a) comprises:
an ohmic contact layer in direct contact with the third portion of said SiC semiconductor structure; and
a barrier layer covering said ohmic contact layer,
said barrier layer being formed by an electrically conducting mid-transition-metal oxide;
said third portion of the SiC semiconductor structure is doped; and
said first portion of the SiC semiconductor structure is arranged between said second portion (4) and said third portion (5) to form a field effect transistor structure.

5. The field effect gas sensor (1; 20; 30) according to any one of the preceding claims, wherein said ohmic contact layer (9) includes a metal.

6. The field effect gas sensor (1; 20; 30) according to claim 5, wherein said metal is selected from the group consisting of nickel, chromium, titanium, aluminum, tantalum, tungsten, and molybdenum.

7. The field effect gas sensor (1; 20; 30) according to any one of the preceding claims, wherein each of the barrier layer (10) of said second contact structure (8b; 14) and the barrier layer of said third contact structure (8a) is at least partly covered by an insulating passivation layer (11).

8. The field effect gas sensor (1; 20; 30) according to claim 7, wherein at least a portion of at least one of said electron insulating layer and said first contact structure is uncovered by said insulating passivation layer, to allow direct contact by said gas mixture to said portion.

9. A method of manufacturing a field effect gas sensor for detecting a presence of a gaseous substance in a gas mixture, said method comprising the steps of:
providing a SiC semiconductor structure (2; 3; 4; 5; 6) ;
forming an electron insulating layer (7) on a first portion of said SiC semiconductor structure;
depositing a first contact layer (12) on said electron insulating layer;
depositing an ohmic contact layer (9) on a second portion (4) of said SiC semiconductor structure; and
depositing a barrier layer (10) formed by an electrically conducting metal oxide selected from the group of metal oxides consisting of IrO₂, RuO₂, RhO₂, and ReO₃ on said ohmic contact layer (9) to cover said ohmic contact layer.

10. The method according to claim 9, wherein said barrier layer (10) is deposited using a deposition method selected from the group consisting of sputtering and pulsed laser deposition.

## Patentansprüche

1. Feldeffekt-Gassensor (1; 20; 30) zum Erkennen des Vorhandenseins einer gasförmigen Substanz in einem Gasgemisch, wobei der Feldeffekt-Gassensor umfasst:
eine SiC-Halbleiterstruktur (2; 3; 4; 5; 6);
eine Elektronenisolierschicht (7), die einen ersten Abschnitt der SiC-Halbleiterstruktur bedeckt;
eine erste Kontaktstruktur (12), die durch die Elektronenisolierschicht (7) wenigstens teilweise von der SiC-Halbleiterstruktur getrennt ist; und
eine zweite Kontaktstruktur (8b; 14), die leitend mit einem zweiten Abschnitt (4) der SiC-Halbleiterstruktur, der von dem ersten Abschnitt verschieden ist, verbunden ist,
wobei wenigstens entweder die Elektronenisolierschicht (7) und/oder die erste Kontaktstruktur (12) dafür ausgelegt ist, mit der gasförmigen Substanz in Wechselwirkung zu treten, um eine elektrische Eigenschaft der SiC-Halbleiterstruktur zu ändern; und wobei die zweite Kontaktstruktur (8b; 14) umfasst:
eine ohmsche Kontaktschicht (9) in direktem Kontakt mit dem zweiten Abschnitt (4) der SiC-Halbleiterstruktur; und
eine Sperrschicht (10), die die ohmsche Kontaktschicht bedeckt,
wobei die Sperrschicht durch ein elektrisch leitendes Metalloxid gebildet wird, das aus der Gruppe der Metalloxide bestehend aus IrO₂, RuO₂, RhO₂ und ReO₃ ausgewählt ist.

2. Feldeffekt-Gassensor (1; 20; 30) gemäß Anspruch 1, wobei das elektrisch leitende Oxid eines mittleren Übergangsmetalls aus der Gruppe bestehend aus Iridiumoxid und Rhodiumoxid ausgewählt ist.

3. Feldeffekt-Gassensor (1; 20; 30) gemäß Anspruch 1 oder 2, wobei der zweite Abschnitt der SiC-Halbleiterstruktur dotiert ist.

4. Feldeffekt-Gassensor (1) gemäß Anspruch 3, der ferner eine dritte Kontaktstruktur (8a) umfasst, die leitend mit einem dritten Abschnitt (5) der SiC-Halbleiterstruktur, der von dem ersten Abschnitt und dem zweiten Abschnitt (4) verschieden ist, verbunden ist, wobei:
die dritte Kontaktstruktur (8a) umfasst:
eine ohmsche Kontaktschicht in direktem Kontakt mit dem dritten Abschnitt der SiC-Halbleiterstruktur; und
eine Sperrschicht, die die ohmsche Kontaktschicht bedeckt,
wobei die Sperrschicht durch ein elektrisch leitendes Oxid eines mittleren Übergangsmetalls gebildet ist;
der dritte Abschnitt der SiC-Halbleiterstruktur dotiert ist; und
der erste Abschnitt der SiC-Halbleiterstruktur zwischen dem zweiten Abschnitt (4) und dem dritten Abschnitt (5) angeordnet ist, um eine Feldeffekttransistorstruktur zu bilden.

5. Feldeffekt-Gassensor (1; 20; 30) gemäß einem der vorstehenden Ansprüche, wobei die ohmsche Kontaktschicht (9) ein Metall aufweist.

6. Feldeffekt-Gassensor (1; 20; 30) gemäß Anspruch 5, wobei das Metall aus der Gruppe bestehend aus Nickel, Chrom, Titan, Aluminium, Tantal, Wolfram und Molybdän ausgewählt ist.

7. Feldeffekt-Gassensor (1; 20; 30) gemäß einem der vorstehenden Ansprüche, wobei sowohl die Sperrschicht (10) der zweiten Kontaktstruktur (8b; 14) als auch die Sperrschicht der dritten Kontaktstruktur (8a) wenigstens teilweise von einer isolierenden Passivierungsschicht (11) bedeckt ist.

8. Feldeffekt-Gassensor (1; 20; 30) gemäß Anspruch 7, wobei wenigstens ein Abschnitt von wenigstens entweder der Elektronenisolierschicht und/oder der ersten Kontaktstruktur nicht von der isolierenden Passivierungsschicht bedeckt ist, um einen direkten Kontakt des Gasgemisches mit diesem Abschnitt zu ermöglichen.

9. Verfahren zur Herstellung eines Feldeffekt-Gassensors zum Erkennen des Vorhandenseins einer gasförmigen Substanz in einem Gasgemisch, wobei das Verfahren die folgenden Schritte umfasst:
Bereitstellen einer SiC-Halbleiterstruktur (2; 3; 4; 5; 6) ;
Bilden einer Elektronenisolierschicht (7) auf einem ersten Abschnitt der SiC-Halbleiterstruktur;
Abscheiden einer ersten Kontaktschicht (12) auf der Elektronenisolierschicht;
Abscheiden einer ohmschen Kontaktschicht (9) auf einem zweiten Abschnitt (4) der SiC-Halbleiterstruktur; und Abscheiden einer Sperrschicht (10), die durch ein elektrisch leitendes Metalloxid gebildet wird, das aus der Gruppe der Metalloxide bestehend aus IrO₂, RuO₂, RhO₂ und ReO₃ ausgewählt ist, auf der ohmschen Kontaktschicht (9), um die ohmsche Kontaktschicht zu bedecken.

10. Verfahren gemäß Anspruch 9, wobei die Sperrschicht (10) unter Verwendung eines Abscheidungsverfahrens abgeschieden wird, das aus der Gruppe bestehend aus Sputtern und gepulster Laserabscheidung ausgewählt ist.

## Revendications

1. Capteur de gaz à effet de champ (1 ; 20 ; 30), destiné à détecter la présence d'une substance gazeuse dans un mélange de gaz, ledit capteur de gaz à effet de champ comprenant :
une structure semi-conductrice en SiC (2 ; 3 ; 4 ; 5 ; 6) ;
une couche isolante électronique (7) recouvrant une première partie de ladite structure semi-conductrice en SiC ;
une première structure de contact (12) au moins partiellement séparée de ladite structure semi-conductrice en SiC par ladite couche isolante électronique (7) ; et
une deuxième structure de contact (8b ; 14) reliée par conduction à une deuxième partie (4) de ladite structure semi-conductrice en SiC, différente de ladite première partie,
dans lequel ladite couche isolante électronique (7) et/ou ladite première structure de contact (12) sont configurées pour interagir avec ladite substance gazeuse pour modifier une propriété électrique de ladite structure semi-conductrice en SiC ; et
dans lequel ladite deuxième structure de contact (8b ; 14) comprend :
une couche de contact ohmique (9) en contact direct avec la deuxième partie (4) de ladite structure semi-conductrice en SiC ; et
une couche barrière (10) recouvrant ladite couche de contact ohmique,
ladite couche barrière étant formée par un oxyde métallique électriquement conducteur choisi dans le groupe d'oxydes métalliques constitué par IrO₂, RuO₂, RhO₂ et ReO₃.

2. Capteur de gaz à effet de champ (1 ; 20 ; 30) selon la revendication 1, dans lequel ledit oxyde de métal de transition central électriquement conducteur est choisi dans le groupe constitué par l'oxyde d'iridium et l'oxyde de rhodium.

3. Capteur de gaz à effet de champ (1 ; 20 ; 30) selon la revendication 1 ou 2, dans lequel ladite deuxième partie de la structure semi-conductrice en SiC est dopée.

4. Capteur de gaz à effet de champ (1) selon la revendication 3, comprenant en outre une troisième structure de contact (8a) reliée par conduction à une troisième partie (5) de ladite structure semi-conductrice en SiC, différente de ladite première partie et de ladite deuxième partie (4),
dans lequel :
ladite troisième structure de contact (8a) comprend :
une couche de contact ohmique en contact direct avec la troisième partie de ladite structure semi-conductrice en Sic ; et
une couche barrière recouvrant ladite couche de contact ohmique,
ladite couche barrière étant formée par un oxyde de métal de transition central électriquement conducteur ;
ladite troisième partie de la structure semi-conductrice en SiC est dopée ; et
ladite première partie de la structure semi-conductrice en SiC est disposée entre ladite deuxième partie (4) et ladite troisième partie (5) pour former une structure de transistor à effet de champ.

5. Capteur de gaz à effet de champ (1 ; 20 ; 30) selon l'une quelconque des revendications précédentes, dans lequel ladite couche de contact ohmique (9) comporte un métal.

6. Capteur de gaz à effet de champ (1 ; 20 ; 30) selon la revendication 5, dans lequel ledit métal est choisi dans le groupe constitué par le nickel, le chrome, le titane, l'aluminium, le tantale, le tungstène et le molybdène.

7. Capteur de gaz à effet de champ (1 ; 20 ; 30) selon l'une quelconque des revendications précédentes, dans lequel la couche barrière (10) de ladite deuxième structure de contact (8b ; 14) et la couche barrière de ladite troisième structure de contact (8a) sont chacune au moins partiellement recouvertes par une couche de passivation isolante (11).

8. Capteur de gaz à effet de champ (1 ; 20 ; 30) selon la revendication 7, dans lequel au moins une partie de ladite couche isolante électronique et/ou de ladite première structure de contact n'est pas recouverte par ladite couche de passivation isolante, pour permettre un contact direct dudit mélange de gaz avec ladite partie.

9. Procédé de fabrication d'un capteur de gaz à effet de champ destiné à détecter la présence d'une substance gazeuse dans un mélange gaz, ledit procédé comprenant les étapes suivantes :
se procurer une structure semi-conductrice en SiC (2 ; 3 ; 4 ; 5 ; 6) ;
former une couche isolante électronique (7) sur une première partie de ladite structure semi-conductrice en SiC ;
déposer une première couche de contact (12) sur ladite couche isolante électronique ;
déposer une couche de contact ohmique (9) sur une deuxième partie (4) de ladite structure semi-conductrice en SiC ;
déposer une couche barrière (10) formée par un oxyde métallique électriquement conducteur choisi dans le groupe d'oxydes métalliques constitué par IrO₂, RuO₂, RhO₂, et ReO₃ sur ladite couche de contact ohmique (9) pour recouvrir ladite couche de contact ohmique.

10. Procédé selon la revendication 9, dans lequel ladite couche barrière (10) est déposée par un procédé de dépôt choisi dans le groupe constitué par la pulvérisation cathodique et le dépôt par laser pulsé.
